# FASCICULE DE BREVET EUROPEEN

(11) **EP 3 820 265 B1**
(45) Date de publication et mention de la délivrance du brevet: **30.08.2023**
(21) Numéro de dépôt: 20206281.6
(22) Date de dépôt: 06.11.2020
(51) Int. Cl.: H05K 13/04

(54) **PROCÉDÉ ET DISPOSITIF DE DÉCOUPE D'UN COMPOSANT ÉLECTRONIQUE RADIAL**
VERFAHREN UND VORRICHTUNG ZUM SCHNEIDEN EINES RADIALEN ELEKTRONISCHEN BAUTEILS
METHOD AND DEVICE FOR CUTTING A RADIAL ELECTRONIC COMPONENT

(30) Priorité: 08.11.2019 FR 1912556
(43) Date de publication de la demande: 12.05.2021
(73) Titulaire: Semo, 31700 Cornebarrieu (FR)
(72) Inventeur: CLARMONT, Jean-Jacques, 31270 Cugnaux (FR); SOLIE, Jérémy, 31700 Beauzelle (FR); RIVAS, Fabien, 31470 Fonsorbes (FR)
(74) Mandataire: Plasseraud IP

(56) Documents cités:
- EP-A1- 0 405 977
- EP-A1- 3 332 623
- JP-A- S60 128 164

## Description

La présente invention concerne un procédé et un dispositif de séparation d'un composant électronique radial de son support.

### Domaine technique

Le domaine technique concerné ici est le montage de composants électroniques radiaux sur une carte électronique, comme par exemple une carte de type « carte de circuit imprimé » plus connue sous le sigle anglais PCB (pour Printed Circuit Board). Les composants électroniques radiaux comportent deux pattes de liaison, le plus souvent parallèles, qui s'étendent depuis un même côté du composant.

Les composants électroniques radiaux sont classiquement fournis par les fabricants de composants électroniques alignés régulièrement sur une bande de papier (ou carton ou similaire), les extrémités libres des pattes des composants étant collées sur ladite bande. Cette bande est perforée pour permettre de la tracter. Elle est en fait constituée de deux bandes collées l'une à l'autre, les extrémités de pattes de composants étant prises en sandwich entre les deux bandes à une position précise par rapport aux perforations de la bande.

### Technique antérieure

Pour le montage de tels composants sur une carte électronique, il convient de séparer chaque composant de la bande sur laquelle il se trouve. De manière classique, les pattes du composant sont coupées entre la bande de papier et le composant proprement dit. Pour réaliser la découpe, la bande de papier est tractée par un dispositif d'entrainement à l'aide de ses trous et passe devant un poste de découpe dans lequel les pattes d'un composant sont coupées et le composant est saisi pour venir alimenter un dispositif de mise en place du composant sur une carte électronique.

Il a été remarqué que généralement, avec les dispositifs de coupe utilisés, on obtient des composants, après détachement de la bande, avec des pattes de longueur différentes. Le plus souvent, cette différence de longueur est négligeable et ne perturbe pas le montage ultérieur des composants mais il peut arriver que si le composant a des pattes trop courtes ou trop longues, il soit mal monté sur la carte électronique. En effet, la coupe est habituellement réalisée en prenant comme référence les trous de la bande perforée et donc la longueur des pattes du composant dépend alors pour le moins, d'une part, de la précision de réalisation des trous dans la bande et, d'autre part, de la précision du positionnement et collage du composant sur la bande.

Le document EP0405977 concerne, d'après son abrégé, concerne un appareil de coupe de fils de connexion de composants pour composants électriques à fils de connexion radiaux entraînés sur une bande. Les composants sur bande sont entraînés à travers la machine par une roue à mouvement rotatif intermittent, avec les éléments du poste de coupe adjacents à la périphérie de la roue. Des éléments de matrice de découpage et de serrage sont disposés dans le poste de coupe, et sont actionnés par un rouleau pneumatique pour bloquer et couper les composants à fils de connexion. L'appareil comprend des éléments de réglage facilement accessibles par la partie supérieure de la machine pour relever ou abaisser la roue à mouvement intermittent et par conséquent pour ajuster les différentes longueurs de coupe des fils de connexion, et pour positionner la roue pour s'adapter aux différentes configurations des ouvertures du tambour d'entraînement de la bande.

Le document EP3332623 concerne un dispositif pour détacher des composants électroniques radiaux d'une bande de composants. Le dispositif comprend un élément de coupe pour couper des conducteurs d'un composant électronique radial, un limiteur pour aligner le composant électronique radial par rapport à l'élément de coupe dans une première direction, et des moyens pour agencer un corps du composant électronique radial contre le limiteur. Ce document concerne en outre un procédé pour détacher des composants électroniques radiaux d'une bande de composants.

Le document JPS60128164A concerne un appareil pour alimenter un composant sur ruban adhésif dans une machine automatique de montage de composants.

La présente divulgation a alors pour but de fournir des moyens permettant de maitriser la longueur des pattes d'un composant électronique lorsqu'il est séparé de la bande sur laquelle il est conditionné.

### Résumé

La présente divulgation vient améliorer la situation.

Il est tout d'abord proposé un procédé de séparation d'un composant électronique radial comportant deux pattes d'une bande support perforée, ledit composant étant fixé sur la bande support perforée par les extrémités libres de ses pattes. Ledit procédé comporte les étapes suivantes :
- mise en place d'un composant par action sur la bande support dans un poste de séparation, la bande se déplaçant le long d'un parcours prédéterminé,
- introduction d'une butée mobile entre les pattes du composant, entre le composant électronique et sa bande support perforée,
- pincement des deux pattes du composant avec une contrainte contrôlée,
- positionnement du composant par traction sur la bande support perforée dans une direction opposée au composant électronique de manière à assurer un contact du composant électronique avec la butée, et
- découpe des deux pattes du composant.

Ce procédé original permet de réaliser un positionnement du composant dans un repère donné. Le composant étant bien placé, il est alors possible de garantir de réaliser à chaque fois une coupe identique avec une même longueur de patte. En effet, la coupe est réalisée en référence au composant et non pas aux trous de la bande support perforée. On remarque que les tolérances de fabrication sur la forme du composant n'ont pas d'influence ici, ni le positionnement du composant sur sa bande support perforée, ni les tolérances sur la réalisation des trous de la bande support perforée.

Il est également proposé un dispositif de séparation d'un composant électronique radial comportant deux pattes d'une bande support perforée, ledit composant étant fixé sur la bande support perforée par les extrémités libres de ses pattes, ledit dispositif de séparation comportant :
- des moyens de déplacement d'une bande support perforée le long d'un parcours prédéterminé,
- une butée mobile entre une première position en dehors du parcours prédéterminé et une seconde position intersectant le parcours prédéterminé,
- un dispositif de serrage avec un serre flanc et une butée fixe disposés de part et d'autre du parcours prédéterminé,
- des moyens destinés à coopérer avec la bande support pour permettre un positionnement du composant par traction sur la bande support, et
- des moyens de découpe destinés à couper deux pattes de composant électronique.

Un tel dispositif est particulièrement adapté pour la mise en oeuvre du procédé décrit plus haut.

Dans une forme de réalisation, les moyens de découpe d'un tel dispositif de séparation comportent une lame mobile en translation selon une direction dite direction de découpe.

Dans cette forme de réalisation :
- la butée mobile peut être en saillie par rapport à la lame dans le sens de la découpe, et/ou
- le dispositif de séparation peut comporter, d'une part, un bâti et, d'autre part, un chariot mobile en translation par rapport audit bâti selon la direction de découpe.

Dans le cas d'un dispositif de séparation avec un bâti, ce dernier peut porter :
- un premier ensemble avec la lame, et
- un second ensemble avec la butée mobile et le serre flanc,

le premier ensemble étant guidé en translation par rapport au bâti ;
le second ensemble étant guidé en translation par rapport au premier ensemble, et des moyens élastiques étant prévus entre le premier ensemble et le second ensemble.

Dans une telle configuration :
- le premier ensemble avec la lame peut présenter en outre un porte lame muni d'un alésage dans lequel coulisse une tête de piston précontrainte élastiquement, la tête de piston étant associée à une tige de piston destinée à pouvoir venir en appui sur le second ensemble, et/ou
- le dispositif de séparation peut comporter en outre un outil de centrage disposé au-dessus du second ensemble, une liaison mécanique étant prévue entre, d'une part, la butée mobile et le serre flanc et, d'autre part, l'outil de centrage. Dans cette variante, l'outil de centrage peut être entrainé en translation par un vérin dédié au déplacement de cet outil de centrage (et des éléments mécaniquement liés à cet outil bien entendu).

Dans le cas d'un dispositif de séparation comportant un bâti et un chariot mobile en translation, ledit dispositif de séparation peut comporter en outre au moins une tige orientée sensiblement selon la direction de découpe qui est sensiblement horizontale, et ladite tige peut être mobile sensiblement selon la direction de découpe et aussi verticalement. Une variante de réalisation prévoit alors que ladite au moins une tige est montée sur un plateau ; que ledit plateau est monté pivotant par rapport au chariot autour d'un axe sensiblement parallèle et perpendiculaire à la direction de découpe, et que le plateau repose sur des moyens de guidage de type came permettant au plateau d'avoir au cours de la course du chariot une portion de déplacement sensiblement parallèle à la direction de découpe puis une autre portion de déplacement avec une composante verticale.

Dans le cas d'un dispositif de séparation comportant un bâti et un chariot mobile en translation, on peut prévoir alternativement que le dispositif de séparation comporte par exemple une tourelle, éventuellement motorisée, comportant des tiges radiales, et que ladite tourelle fait partie d'un bloc mobile verticalement.

Dans le cas d'un dispositif de séparation avec un bâti :
- la direction de découpe peut être sensiblement horizontale, et le bâti peut être réglable verticalement en hauteur par rapport aux moyens de déplacement de la bande support, et/ou
- le bâti peut comporter, d'une part, une face horizontale pour recevoir et guider la butée mobile, le serre flanc et les moyens de découpe et, d'autre part, une platine portant la butée fixe coopérant avec le serre flanc, une fente permettant le passage d'une bande support de composants électroniques étant prévue entre la face horizontale et la platine.

Il est également proposé un dispositif de séparation d'un composant électronique d'une bande support perforée portant des composants électroniques radiaux entrainée par des moyens de support et d'avancement selon une direction d'avancement, ledit dispositif comportant un chariot mobile en translation selon une direction perpendiculaire à la direction d'avancement face au chariot, ledit chariot portant une lame définissant un plan de coupe.

Ici, ce dispositif de séparation comporte en outre un dispositif de positionnement du composant présentant, d'une part, une butée mobile et, d'autre part, un dispositif de traction ;
la butée mobile est montée sur la lame de manière à pouvoir se déplacer selon une direction perpendiculaire à la direction d'avancement face au chariot,
la butée mobile présente au moins une partie en saillie par rapport à la lame et est mobile entre une première position dite position rapprochée et une seconde position dite éloignée dans laquelle la partie en saillie de la butée mobile est plus importante que dans la position rapprochée, ladite butée mobile étant montée précontrainte dans sa position éloignée ;
la butée mobile comporte en outre un serre flan destiné à coopérer avec une butée fixe faisant face au chariot pour venir serrer des pattes de composant entre ledit serre flan et la butée fixe ;
le dispositif de traction comporte au moins une tige mobile, d'une part, selon une direction sensiblement parallèle à la direction de déplacement de la lame et de la butée mobile et, d'autre part, selon une direction perpendiculaire à cette direction et à la direction d'avancement face au chariot.

Ce dispositif est également bien adapté pour mettre en oeuvre le procédé proposé ci-dessus. Dans ce dispositif, les divers éléments nommés (lame, chariot, butée mobile, ...) peuvent bien entendu être composés de plusieurs pièces assemblées.

Dans ce dispositif, la lame peut comporter par exemple un alésage dans lequel coulisse une tête de piston précontrainte élastiquement, la tête de piston étant associée à une tige de piston destinée à pouvoir venir en appui sur la butée mobile. Cette structure permet de bien maitriser les forces dans les diverses étapes de réalisation du procédé pour l'opération de séparation (coupe).

La partie en saillie de la butée mobile comporte avantageusement une plaque parallèle au plan de coupe formant le serre flan et une nervure s'étendant perpendiculairement au plan de coupe et à la direction d'avancement. Dans cette forme de réalisation, le serre flan et la nervure peuvent former une pièce distincte fixée par vissage sur l'ensemble mobile formant la butée mobile. Cette variante est avantageuse car il suffit alors de changer cette pièce pour adapter le dispositif à un nouveau type de composant.

Selon une forme de réalisation avantageuse, on peut prévoir que la tige mobile du dispositif de traction est montée sur un bras monté pivotant autour d'un axe parallèle au plan de coupe et perpendiculaire à la direction d'avancement, ledit axe étant monté sur le chariot. Dans ce cas, il est avantageux de prévoir en outre que le bras monté pivotant coopère avec une came fixe en étant précontraint en direction de la came.

Pour que le dispositif puisse s'adapter à une unité déjà existante dans laquelle un dispositif d'entrainement de bande support perforée est déjà préexistant, l'ensemble formé par la lame et la butée mobile est avantageusement monté coulissant selon une direction perpendiculaire au plan de coupe.

### Brève description des dessins

D'autres caractéristiques, détails et avantages apparaîtront à la lecture de la description détaillée ci-après, et à l'analyse du dessin annexé, sur lequel :
**Fig. 1**

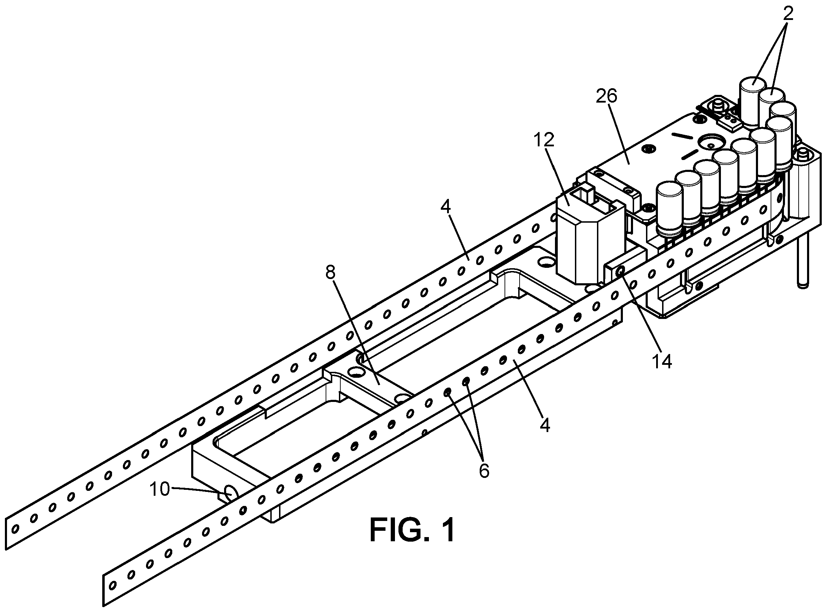

   [Fig. 1] montre une vue d'ensemble d'un dispositif de séparation d'un composant radial selon un premier mode de réalisation.
**Fig. 2**

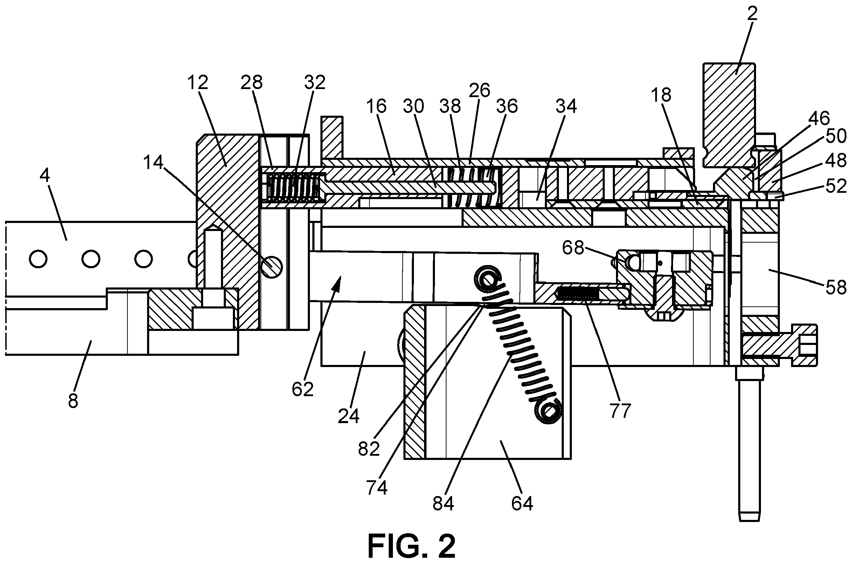

   [Fig. 2] montre une vue en coupe longitudinale à échelle agrandie d'une partie de l'ensemble de la figure 1.
**Fig. 3**

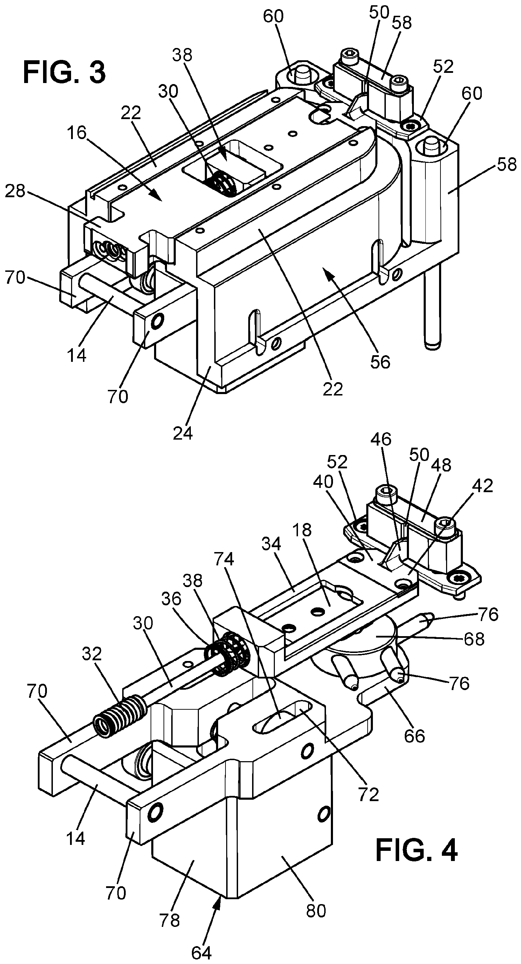

   [Fig. 3] montre en perspective une partie du dispositif destinée à réaliser une découpe de pattes de composant.
**Fig. 4**
   [Fig. 4] est une vue similaire à la figure 3, des pièces ayant été retirées pour montrer l'intérieur de la structure.
**Fig. 5**

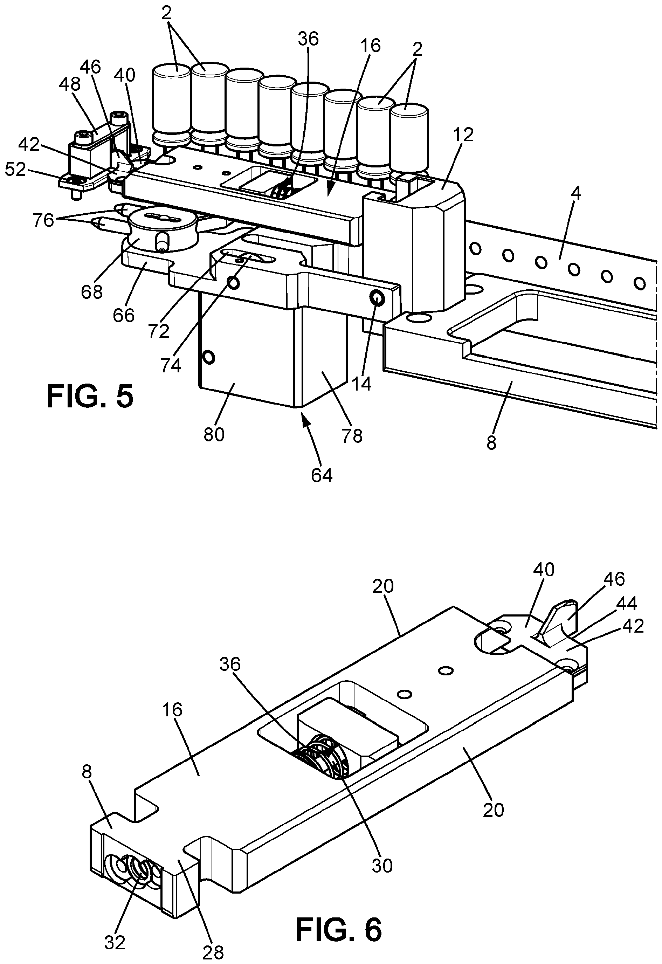

   [Fig. 5] est une autre vue en perspective, selon un angle différent montrant le dispositif destiné à réaliser une découpe des pattes de composants radiaux et un dispositif de positionnement.
**Fig. 6**
   [Fig. 6] est une vue en perspective de détail d'une partie du dispositif de découpe de la figure 3.
**Fig. 7**

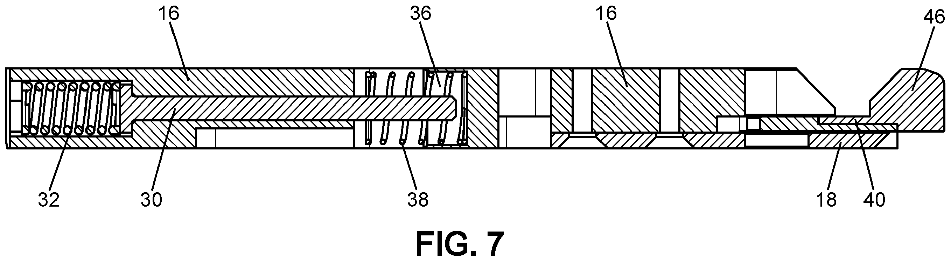

   [Fig. 7] montre les éléments de la figure 6 en coupe longitudinale.
**Fig. 8**

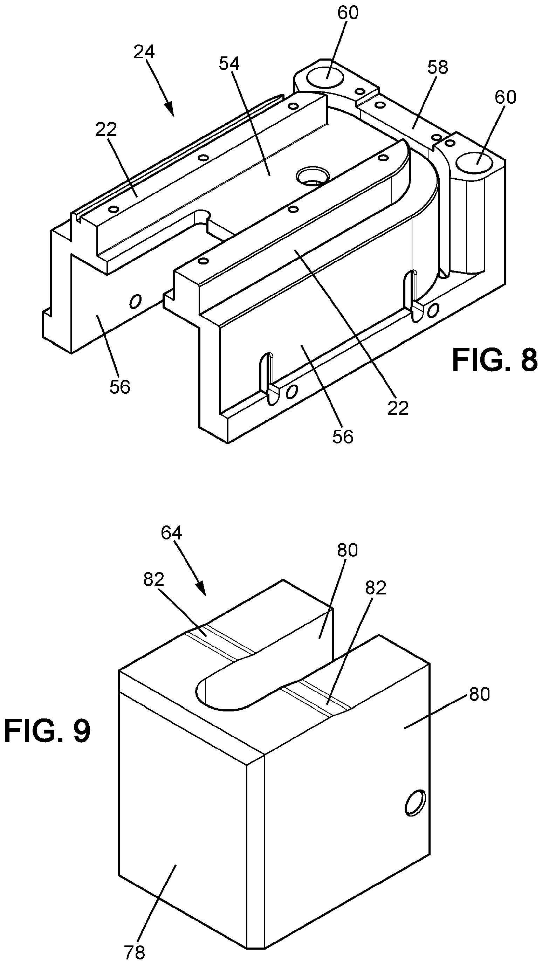

   [Fig. 8] montre un élément de la structure en perspective.
**Fig. 9**
   [Fig. 9] montre un autre élément de la structure selon cette perspective.
**Fig. 10**

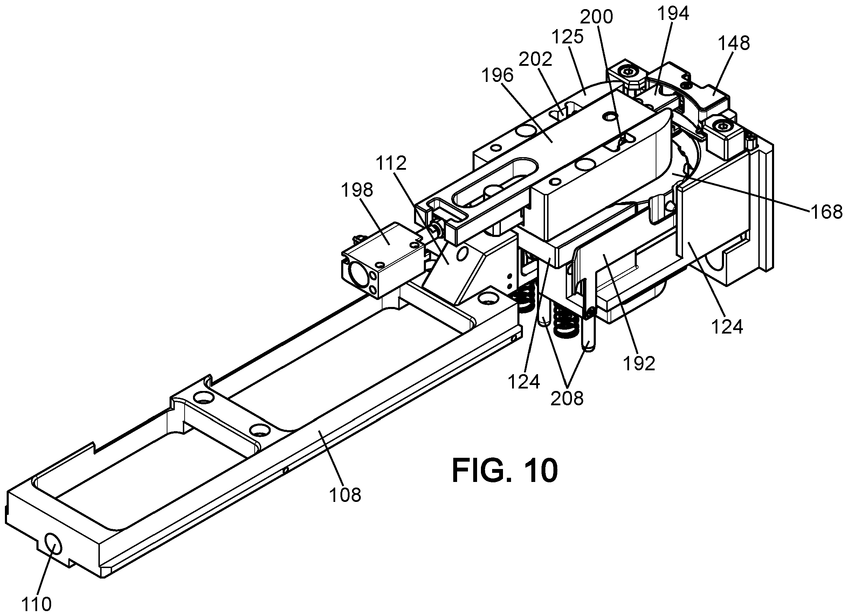

   [Fig. 10] est une vue en perspective d'un dispositif de séparation d'un composant radial selon un deuxième mode de réalisation.
**Fig. 11**

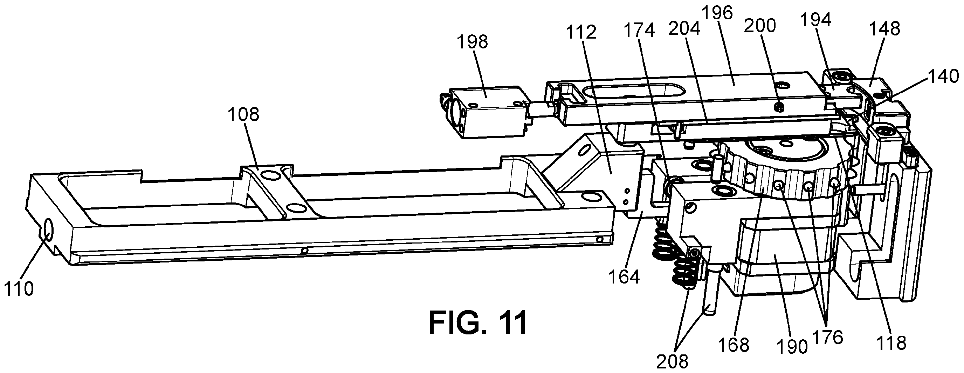

   [Fig. 11] est une vue en perspective du dispositif de séparation d'un composant radial de la figure 10 vu sous un angle différent et des pièces ayant été retirée pour mieux voir l'intérieur du dispositif.
**Fig. 12**

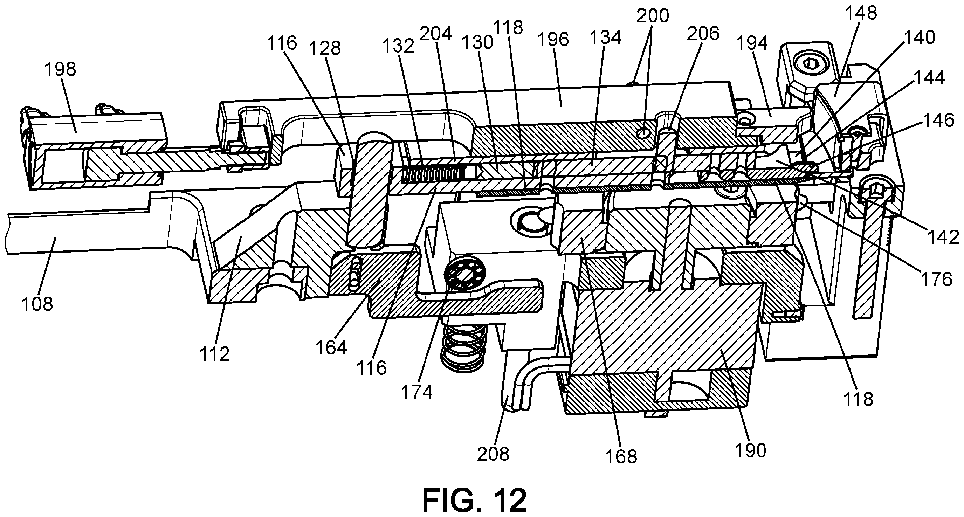

   [Fig. 12] est une vue en coupe longitudinale correspondant à la vue de la figure 11.
**Fig. 13**

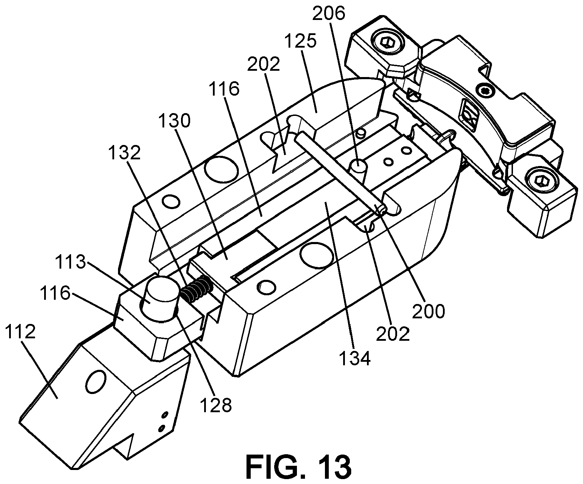

   [Fig. 13] est une vue en perspective d'une partie de l'outil de découpe du dispositif figure 10 à 12.

### Description des modes de réalisation

Les figures et la description ci-après contiennent, pour l'essentiel, des éléments de caractère certain. Elles pourront donc non seulement servir à mieux faire comprendre la présente divulgation mais aussi contribuer à sa définition, le cas échéant.

Il est maintenant fait référence à la figure 1. On reconnait sur cette figure tout d'abord des composants radiaux 2, par exemple des condensateurs, qui sont rangés de manière classique sur une bande support 4 perforée. Chaque composant radial comporte deux pattes dont les extrémités libres se trouvent au niveau de la bande support 4. Dans la pratique, la bande support 4 est formée de deux bandes de papier collées l'une à l'autre et les pattes des composants radiaux 2 sont prises en sandwich entre les deux bandes de papier. On remarque la présence de trous 6 dans la bande support 4. Ces trous 6 sont régulièrement disposés tout le long de la bande support 4 et les pattes des composants radiaux 2 sont toujours disposées d'une même manière par rapport aux trous 6, par exemple les deux pattes d'un composant radial 2 se trouvent à chaque fois entre deux trous 6 successifs ou bien, comme ici, les deux pattes d'un composant radial 2 se trouvent à chaque fois de part et d'autre d'un trou 6.

La figure 1 illustre une bande support 4 perforée mais uniquement quelques composants radiaux 2 disposés sur la bande support 4 : sur la partie de la bande support 4 se trouvant à gauche de la figure, il n'y a pas de composants radiaux car ceux-ci ont été séparés de la bande support 4 mais sur la partie de la bande support 4 se trouvant à droite de la figure, seuls quelques composants radiaux 2 ont été représentés pour éviter de surcharger la figure.

On reconnait aussi sur la figure 1 un outil pour réaliser la séparation des composants radiaux 2 se trouvant sur la bande support 4 de cette dernière. Ce dispositif est monté sur un châssis 8 actionné par un vérin (non représenté) venant se raccorder à une extrémité du châssis 8 à l'aide d'un alésage 10 prévu à cet effet. Dans la forme de réalisation illustrée à titre d'exemple non limitatif, le châssis 8 se présente sous la forme d'un cadre rectangulaire allongé avec deux grands côtés dits côtés longitudinaux et deux autres côtés dits côtés transversaux. Un dispositif de séparation est monté sur un côté transversal du châssis tandis que l'alésage 10 pour le raccord d'une tige de vérin d'actionnement se trouve sur le côté transversal opposé.

On suppose dans la suite de la description que le châssis 8 est horizontal. On appellera en outre direction longitudinale la direction correspondant à l'axe du vérin d'actionnement qui agit horizontalement et parallèlement aux côtés longitudinaux du châssis 8. On suppose en outre que les composants radiaux 2 se trouvent au-dessus de leur bande support 4 perforée.

La présente description de ce mode de réalisation ne concerne pas des moyens d'entrainement de la bande support 4 perforée. Cette dernière est disposée verticalement. Comme on le remarque sur la figure 1, elle se déplace tout d'abord longitudinalement puis dans une direction transversale avant de reprendre une direction longitudinale. La bande support 4 se déplace ainsi selon un parcours prédéterminé le long du châssis 8 dans un premier sens, vers le dispositif de séparation, puis passe devant le dispositif de séparation avant de longer à nouveau le châssis 8 longitudinalement mais dans un sens opposé au premier sens. La direction d'avancement de la bande support 4 qui nous intéresse est sa direction transversale car c'est lorsque la bande support 4 se déplace transversalement qu'elle coopère avec le dispositif de séparation qui vient séparer les composants radiaux 2 de la bande support 4.

Le dispositif de séparation comporte une glissière verticale 12 qui est montée sur le bord transversal du châssis 8 opposé à l'alésage 10. La glissière verticale 12 est une pièce profilée qui s'étend verticalement et présente sur sa face opposée au châssis 8 une rainure verticale présentant ici une forme de T. Dans cette rainure verticale vient coulisser une unité de découpe.

On remarque en outre que la glissière verticale 12, dans sa partie inférieure, est munie d'un alésage traversant servant de palier à un axe transversal 14. Ce dernier porte une unité de positionnement d'un composant radial 2 par rapport à l'unité de découpe.

Des éléments de l'unité de découpe sont représentés plus en détails sur les figures 6 et 7. Sur ces figures, on a représenté un premier ensemble et un second ensemble.

Le premier ensemble présente un porte lame 16 sur lequel est vissée une lame 18.

Le porte lame 16 présente une forme globale rectangulaire et s'étend à l'horizontale dans l'ensemble monté de la figure 1. Il présente des bords longitudinaux 20 qui sont destinés à venir prendre place entre deux rails 22 d'un bâti 24 illustré sur la figure 8. Un couvercle 26 (figures 1 et 2) est vissé sur les rails 22 à l'aide de six vis et permet de maintenir le porte lame 16 entre les deux rails 22.

Le porte lame 16 comporte en outre une queue 28 en T destinée à venir prendre place dans la rainure de la glissière verticale 12. Du côté de la queue 28, le porte lame 16 présente un alésage qui reçoit une tête d'un piston 30 précontrainte élastiquement par un premier ressort 32 qui vient en appui, d'une part, sur le fond de la rainure de la glissière verticale 12 et, d'autre part, sur la tête du piston 30 (figure 7).

Du côté opposé à la queue 28, le porte lame 16 porte la lame 18 qui est fixée sous le porte lame 16 par vissage. La lame 18 fait saillie en avant du porte lame 16 du côté opposé à la queue 28.

Le second ensemble des figures 6 et 7 est imbriqué dans le premier ensemble et est mobile longitudinalement par rapport à ce premier ensemble. Il comporte un cadre 34 visible en perspective sur la figure 4 par exemple. Ce cadre 34 comporte un évidement intérieur (figure 4) servant au passage des vis utilisées pour la fixation de la lame 18 sur le porte lame 16. La lame 18 coulisse entre des bords longitudinaux du cadre 34 lors d'un déplacement longitudinal relatif de la lame 18 par rapport au cadre. Le cadre 34 porte à l'arrière, c'est-à-dire du côté orienté vers la glissière verticale 12, un logement borgne 36 recevant, d'une part, un deuxième ressort 38 venant en appui sur le fond du logement borgne 36 et sur le porte lame 16 et, d'autre part, l'extrémité libre de la tige du piston 30. Le deuxième ressort 38 est par exemple un ressort hélicoïdal disposé autour de ladite tige. Ce deuxième ressort 38 présente une raideur moindre que celle du premier ressort 32.

À l'avant, c'est-à-dire du côté opposé au logement borgne 36, le cadre 34 porte une pièce appelée par la suite repère 40 qui est destinée à servir, comme il sera expliqué plus tard, de serre flan pour les pattes d'un composant radial 2 et de référence pour le positionnement du composant radial lors de l'opération de séparation du composant de sa bande support 4 perforée. Le repère 40 présente une plaque horizontale 42 comportant un bord transversal avant 44, qui est en saillie du cadre 34 et s'étend à la verticale, ainsi qu'une lame verticale 46 destinée à venir prendre place entre les pattes d'un composant radial 2 et dont le bord supérieur sert de surface de référence pour venir supporter le composant proprement dit avant que ses pattes ne soient coupées pour le séparer de sa bande support 4. La lame verticale 46 forme une butée contre laquelle il est prévu de venir faire reposer le composant radial 2. La forme de lame est choisie ici pour pouvoir venir prendre place entre les pattes du composant radial 2. Une autre forme pourrait également convenir. L'arête supérieure de la lame verticale sert alors de référence pour le positionnement par la suite du composant radial. On remarque que cette lame verticale 46, et donc son arête supérieure, est fixe par rapport au plan de coupe défini par la lame 18 destinée à réaliser la découpe des pattes du composant. La lame verticale 46 forme ainsi une butée de référence pour la découpe des pattes du composant radial 2.

Le premier ensemble et le second ensemble décrits ci-dessus sont montés sur le bâti 24 qui porte également un bloc d'appui 48 visible par exemple en perspective sur la figure 4. Ce bloc d'appui 48 est destiné à permettre de maintenir le composant radial 2 qui est séparé de sa bande support 4 lors de l'opération de séparation. Ce bloc d'appui 48 présente ainsi un corps dans lequel est réalisée une fente verticale 50 dans laquelle peut venir se loger la lame verticale 46 ou tout du moins au moins une extrémité distale (ou avant) de cette lame verticale 46. Il comporte en outre une plaque d'appui 52 se trouvant à la hauteur de la plaque horizontale 42 faisant office de serre flan de telle sorte que les pattes d'un composant radial 2 puissent être maintenues entre la plaque d'appui 52 et la plaque horizontale 42 lors d'une opération de séparation. Le bloc d'appui 48 est un ensemble supposé fixe monté sur le bâti 24. Le bloc d'appui 48 se trouve entièrement d'un côté du parcours de la bande support 4.

Le bâti 24 illustré sur la figure 8 comprend une face horizontale 54 pour recevoir le premier ensemble comportant le porte lame 16 et sa lame 18 ainsi que le second ensemble comportant le cadre 34. Les rails 22 se trouvent sur cette face horizontale 54 et assurent le guidage longitudinal du premier ensemble (au sein duquel se déplace aussi le second ensemble comme illustré sur les figures 6 et 7).

La face horizontale 54 est montée sur deux flancs latéraux 56 longitudinaux. Les bords inférieurs des flancs latéraux 56 se prolongent vers l'avant pour porter une platine 58 sur laquelle est fixé le bloc d'appui 48. Comme on peut le voir, la platine 58 présente des alésages verticaux 60 pour assurer un guidage du bâti 24 lors d'un déplacement vertical (réglage en hauteur de la coupe) de celui-ci.

Le bâti 24 est positionné de telle sorte que la bande support 4 perforée longe les deux flancs latéraux 56 et passe dans une fente que l'on aperçoit entre la platine 58 et la face horizontale 54 du bâti. Cette fente délimite le parcours de la bande support 4.

L'ensemble porté par le bâti 24 et le bâti lui-même peuvent se translater en hauteur le long de la glissière verticale12. Il est ainsi possible de régler en hauteur la lame 18, le serre flan et la lame verticale 46 ainsi que le bloc d'appui en fonction des composants radiaux à séparer et de la longueur des pattes souhaitée après découpe. Toutefois, le bâti 24 ne se déplace pas au cours d'une opération de découpe et est de ce fait supposé fixe. Il n'est éventuellement déplacé que lors d'un changement de composant et/ou d'une modification de la longueur de coupe des pattes des composants.

Le dispositif de séparation comporte aussi, comme indiqué plus haut, une unité de positionnement. Cette dernière comporte entre autres éléments un bras pivotant 62 monté sur l'axe transversal 14 et une came 64 (figures 2 à 5 notamment).

Le bras pivotant 62 comporte un plateau 66 portant une tourelle 68, ledit plateau 66 étant raccordé par deux branches 70 à l'axe transversal 14 de la glissière verticale 12. Chaque branche 70 présente une fente verticale 72 dans laquelle est logée une roue 74 dimensionnée (ou positionnée) de manière à faire saillie en-dessous de la branche 70 correspondante.

La tourelle 68 est montée pivotante sur le plateau 66 autour d'un axe perpendiculaire à celui-ci. Elle porte des tiges 76 destinées à coopérer avec les trous 6 de la bande support 4 perforée.

La présence de la tourelle 68 est optionnelle. Elle permet de s'adapter à la disposition des trous 6 sur une bande support 4 perforée par rapport aux composants radiaux 2. La tourelle 68 présente à sa périphérie plusieurs (a priori de deux à quatre) configurations de positions de tiges 76 pour s'adapter à la bande support 4 perforée. La configuration adaptée à la bande support 4 perforée est alors placée de telle sorte que les tiges 76 (ou la tige) correspondante soit orientées longitudinalement vers l'avant, c'est-à-dire vers la platine 58. L'extrémité libre de chaque tige 76 est de préférence conique ou pour le moins tronconique, le diamètre de la tige 76 correspondant sensiblement au diamètre des trous 6 (en étant bien sûr légèrement inférieur).

Comme illustré sur la figure 2, les configurations de la tourelle 68 sont de préférence indexées à l'aide d'un doigt 77 précontraint par un ressort.

La came 64 est une pièce fixe par rapport au système d'entrainement de la bande support 4 perforée. Les autres pièces décrites précédemment sont mobiles par rapport à ce système d'entrainement : le châssis 8 et la glissière verticale 12 se déplacent en translation longitudinale horizontale. Le premier ensemble (avec le porte lame 16 et la lame 18 notamment) et le second ensemble (avec notamment le cadre 34 et le repère 40 avec la lame verticale 46) se déplacent aussi longitudinalement par rapport au bâti 24. Ce dernier est supposé fixe (même s'il est réglable en hauteur comme expliqué plus haut). La came 64 est solidaire, sans possibilité de réglage, par rapport au dispositif d'entrainement de la bande support 4 perforée.

Cette came 64 se présente sous la forme d'un étrier avec une base 78 verticale de laquelle s'étendent longitudinalement deux parois longitudinales 80 présentant chacune sur sa face supérieure deux zones sensiblement horizontales entre lesquelles se trouve un plan incliné 82.

Les roues 74 du bras pivotant 62 viennent rouler chacune sur une face supérieure d'une paroi longitudinale 80 de la came 64. Un troisième ressort 84 vient précontraindre le bras pivotant 62 sur la came 64.

Le fonctionnement du dispositif décrit ci-dessus est alors le suivant. On considère qu'à l'origine, le vérin d'actionnement (non représenté) est dans une position retirée dans laquelle le châssis 8 est éloigné du bâti 24. Le système d'entrainement (non illustré et non décrit) de la bande support 4 perforée est programmé pour déplacer la bande support 4 perforée pas à pas, un pas correspondant ici au pas séparant deux composants radiaux 2 sur la bande support 4 perforée, et pour positionner à chaque fois un composant radial 2 dans une position prédéterminée entre le repère 40 et le bloc d'appui 48. Le repère 40 avec sa lame verticale 46 se trouve alors d'un côté de la bande support 4 (et donc de son parcours) tandis que le bloc d'appui se trouve de l'autre côté de la bande support 4.

Dans la position initiale, les pattes du composant radial 2 à séparer se trouvent sensiblement contre la plaque d'appui 52 du bloc d'appui. La plaque horizontale 42 du repère 40 de même que la lame verticale 46 de ce repère 40 sont encore à distance des pattes du composant à séparer, de même que la lame 18. Du côté de l'unité de positionnement, les extrémités des tiges 76 sont encore à distance de la bande support 4 perforée.

Une fois que le composant radial 2 à séparer de la bande support 4 perforée est bien placé face au dispositif de séparation, le vérin d'actionnement agit pour déplacer le châssis 8 vers le bâti 24. Le bâti 24 ne se déplace pas et est supposé fixe tout au long de l'opération de séparation. La glissière verticale 12 pousse, d'une part, le premier ensemble (avec le porte lame 16 et la lame 18) monté avec le second ensemble (avec le cadre 34 et la lame verticale 46) et, d'autre part, le bras pivotant 62.

Du côté du bras pivotant 62, la came 64 est disposée de telle sorte qu'en début de course, tant que les roues 74 n'atteignent pas le plan incliné 82, les tiges 76 se déplacent longitudinalement en direction de la bande support 4 perforée positionnée de telle sorte que chaque tige 76 se trouve face à un trou 6.

Sur le bâti 24, le premier ensemble, notamment le porte lame 16, coulisse entre les rails 22 et entraine avec lui le cadre 34, le repère 40 et bien entendu la lame 18. La lame verticale 46 du repère 40 vient alors se positionner entre les pattes du composant radial 2 à séparer, en passant sous le composant et en venant se loger partiellement dans la fente verticale 50 du bloc d'appui 48. Cette lame verticale 46, qui en début d'opération de séparation se trouvait entièrement d'un côté de la bande support 4 et donc de sa trajectoire, vient intersecter cette trajectoire et se trouve au niveau de celle-ci.

La structure du dispositif est réalisée de telle sorte que la première pièce à venir en butée lors de ce mouvement longitudinal est la plaque horizontale 42 du repère 40 qui vient buter contre les pattes du composant radial 2 à séparer. Le cadre 34 vient donc s'immobiliser et les pattes du composant radial 2 se trouvent alors prises en sandwich entre, d'une part, le repère 40 et plus précisément le bord transversal avant 44. Le second ensemble est alors immobilisé dans cette position. Lorsque le premier ensemble avec son porte lame 16 continue à avancer, il comprime le deuxième ressort 38. La force de ce ressort 38 vient alors s'exercer sur les pattes du composant radial 2 par appui du bord transversal avant 44 sur lesdites pattes. Cette force doit permettre de maintenir les pattes du composant mais ne pas être trop forte pour que le composant puisse encore se déplacer verticalement.

En effet, pendant que le deuxième ressort 38 se comprime, les tiges 76 se trouvant orientées longitudinalement vers l'avant viennent pénétrer dans les trous 6 de la bande support 4 perforée. Lorsque le deuxième ressort 38 arrive en fin de compression, on prévoit que les roues 74 du bras pivotant arrivent chacune sur le plan incliné 82 correspondant. Lorsque le mouvement du vérin d'actionnement continue, les roues 74 descendent chacune leur plan incliné 82. Des tiges 76 (ou au moins l'une d'entre elle) se trouvant dans un trou 6 de la bande support 4 perforée viennent alors tirer sur les pattes du composant radial 2 à séparer. La force de traction du troisième ressort 84 est suffisante pour permettre de déplacer le composant radial 2 dont les pattes sont serrées entre la plaque horizontale 42 (ou serre flan) et la plaque d'appui 52. Les tiges (ou au moins une tige) 76 tirent jusqu'à ce que le composant à séparer vienne au contact du bord supérieur de la lame verticale 46 du repère 40. Le composant radial 2 à séparer est alors parfaitement positionné par rapport à la lame 18. Celle-ci peut venir couper les pattes du composant pour le séparer de la bande support 4 perforée.

Parallèlement au positionnement du composant à séparer par rapport au repère 40, le premier ensemble avec le porte lame 16 et la lame 18 continue son avancée car il est « directement » entrainé par le vérin d'actionnement (c'est-à-dire que sa course correspond à celle du vérin). La tige du piston 30 vient alors en appui au fond du logement borgne 36 associé au cadre 34. Lorsque le mouvement de translation continue, la lame 18 vient alors sectionner les pattes du composant. Pendant cette découpe, le premier ressort 32 vient se comprimer.

En fin de course, le vérin inverse son mouvement et la lame 18 recule de même que les autres éléments dans le sens inverse sous l'effet notamment des ressorts. On remarque toutefois que le repère 40 recule en dernier. Ceci permet de maintenir le composant séparé de la bande support 4 perforée dans sa position et laisse du temps à un dispositif de préhension pour venir le saisir avant de le transférer vers une unité de montage sur carte.

Les figures 10 à 13 montrent une variante de réalisation d'un dispositif de découpe d'un composant électronique radial. Cette deuxième forme de réalisation présente des caractéristiques qui la distinguent de la première forme de réalisation décrite plus haut. La plupart de ces caractéristiques pourraient être adaptées sur la première forme de réalisation indépendamment des autres. En effet, ces caractéristiques sont pour la plupart indépendantes les unes des autres.

Dans cette deuxième forme de réalisation, les pièces des fonctions similaires à des pièces décrites en relation aux figures 1 à 9 reprennent les mêmes références mais augmentées de 100.

Les figures 10 à 13 ne montrent pas de composants radiaux. Le dispositif illustré sur ces figures est destiné aux mêmes composants radiaux que le dispositif des figures 1 à 9.

La structure globale de cette deuxième forme de réalisation est proche de celle de la première forme de réalisation. On retrouve ainsi un châssis 108 actionné par un vérin (non représenté) venant se raccorder à une extrémité du châssis 108 à l'aide d'un alésage 110 prévu à cet effet sur le châssis. La forme du châssis 108 correspond à celle du châssis 8 décrit plus haut. On suppose ici que ce châssis 108 est horizontal, et plus généralement la même orientation que pour la première forme de réalisation est conservée.

Dans cette deuxième forme de réalisation, des moyens d'entrainement pour une bande support perforée (cf. bande support 4 des figures 1 et 5) sont intégrés au coeur du dispositif. Alors que dans la première forme de réalisation des moyens d'entrainement « extérieurs », connus par ailleurs de l'homme du métier, étaient prévus, un moteur 190 d'entrainement est prévu ici. Ce moteur 190 entraîne une tourelle 168 munie de tiges 176 s'étendant radialement. L'axe du moteur 190 est vertical. Le moteur 190 est disposé en dessous de la tourelle 168 qui présente une forme globale d'un disque (disposé horizontalement). Les tiges 176 sont destinées à coopérer avec des perforations d'une bande support pour composants électroniques. La position des tiges 176 sur la tourelle 168 dépend du diamètre de la tourelle, de la trajectoire de la bande support devant coopérer avec la tourelle 168 et du pas (ou motif) des perforations réalisées dans la bande support.

Le parcours de la bande support reste ici le même que précédemment : la bande support longe le châssis 108 dans un premier sens, passe devant un dispositif de séparation pour longe à nouveau le châssis 108 dans un second sens opposé au premier. La bande support a ainsi un premier tronçon de trajectoire rectiligne (le long du châssis 108) puis sensiblement en arc de cercle sur 180° avant de retrouver une trajectoire rectiligne parallèle et en vis-à-vis du premier tronçon de trajectoire rectiligne. La figure 10 illustre une ceinture de guidage 192 pour permettre le guidage de la bande support. Cette pièce n'est plus représentée sur les figures 11 et 12 pour mieux illustrer les pièces permettant de réaliser la séparation d'un composant électronique.

Comme pour le dispositif des figures 1 à 9, le châssis 108 est relié à un dispositif de séparation avec une première unité pour réaliser une découpe et une seconde unité pour assurer un bon positionnement des éléments de coupe par rapport à la bande support. La première unité est considérée comme une unité fixe avec des outils de coupe mobiles horizontalement. Sa position est toutefois réglable par rapport à un bâti de base pour s'adapter aux composants à séparer de la bande support. La seconde unité est une unité mobile qui se déplace verticalement par rapport audit bâti de base à chaque opération de découpe. Le châssis 108 est quant à lui guidé horizontalement par rapport au bâti de base et se déplace en translation horizontale uniquement.

La première unité pour réaliser des découpes comporte un bâti en deux parties (figure 10) : un bloc de liaison 124 et un bloc guide outil 125. Ce dernier est solidaire du bloc de liaison 124. Ce bâti est monté coulissant par rapport au châssis 108. Alors que dans la forme de réalisation des figures 1 à 9 le guidage entre le bâti 24 et le châssis 8 est réalisé par une glissière 12 avec une rainure en T, c'est-à-dire avec un système de type queue d'aronde, il est prévu ici d'avoir un bloc d'accouplement 112 portant une goupille 113 verticale.

Le bloc guide outil 125 guide tout d'abord une unité de découpe. Par rapport à celle illustrée sur les figures 6 et 7, cette unité remplit une fonction supplémentaire de recentrage du composant électronique avant découpe des pattes dudit composant.

On remarque sur les figures 10 à 12 la présence d'un outil de recentrage 194 porté par un support pour recentrage 196. Le bloc guide outil 125 présente une rainure permettant le guidage horizontal et longitudinal du support pour recentrage 196. Ce support est de forme rectangulaire allongée. Ses grands côtés coopèrent avec la rainure correspondante du bloc guide outil 125 tandis qu'un petit côté porte l'outil de recentrage 194 et que le petit côté opposé est raccordé à un vérin de recentrage 198. Ce vérin présente un corps de vérin solidaire du bloc guide outil 125 par exemple ainsi qu'une tige de vérin reliée au support pour centrage 196. Le support pour recentrage 196 est traversé par une goupille transversale 200 qui présente deux extrémités en saillie dudit support. Ces extrémités libres sont disposées dans des logements 202 dont des parois permettent de limiter la course de la goupille transversale 200 et de ce fait du support pour recentrage 196 et se son outil de recentrage 194 par rapport au bloc guide outil 125.

Sur la figure 13, l'outil de recentrage 194 et son support pour recentrage 196 ont été retirés ainsi qu'un couvercle 204 (figures 11 et 12). On voit alors mieux sur cette figure 13, d'une part, un ensemble serre flanc et, d'autre part, un ensemble porte lame.

L'ensemble serre flanc comporte un outil serre flanc/repère 140 comportant une plaque horizontale 142, un bord transversal avant 144 et une lame verticale 146. Il comporte en outre un guide serre flanc 134 sur lequel est fixé l'outil serre flanc / repère 140. Ce guide serre flanc 134 est de forme rectangulaire allongée et forme ainsi un rail destiné à coulisser dans une rainure longitudinale horizontale formée dans une pièce dite guide lame 116, elle même de forme allongée et guidée horizontalement et longitudinalement dans une rainure du bloc guide outil 125. La rainure servant au guidage du guide serre flanc 134 sert également au guidage d'un poussoir 130 (comparable au piston 30 des figures 2-4, 6 et 7) précontraint par un ressort 132 en appui sur une paroi du guide lame 116. Ce dernier est muni d'un alésage 128 coopérant avec la goupille 113 verticale.

On remarque enfin notamment sur les figures 12 et 13 la présence d'un doigt de liaison 206 entre le guide serre flanc 134 et le support pour recentrage 196 autorisant toutefois un jeu entre les deux pièces liées.

Face à ces outils mobiles, se trouve un bloc d'appui 148 fixé sur le bloc de liaison 124. Ce bloc d'appui 148 est un ensemble fixe destiné à coopérer avec les outils mobiles lui faisant face. Sa forme est adaptée à celle des outils et des composants devant être coupés. Il est fait référence ici à la description plus haut de la première forme de réalisation pour plus de détails.

En ce qui concerne l'entrainement d'une bande support avec des composants et le positionnement des composants avant découpe des pattes de ces composants, comme évoqué plus haut, on a ici une tourelle 168 motorisée pour l'entrainement de la bande support. Cette tourelle 168 et son moteur 190 sont des composants d'un bloc d'entrainement/positionnement monté suspendu et guidé verticalement sur des colonnes de guidage 208. Des ressorts de compression compensent partiellement le poids de ce bloc d'entrainement/positionnement.

Le bloc d'accouplement 112, monté sur le châssis 108, porte une came 164. Alors que dans la première forme de réalisation la came était fixe et que l'ensemble avec la tourelle 68 se déplaçait horizontalement avec le châssis 8, on a ici un bloc avec la tourelle 168 qui est fixe horizontalement (et mobile verticalement) et une came 164 mobile horizontalement. Le bloc avec la tourelle 168 est muni d'au moins une roue 174. La roue 174 et la came 164 sont agencées de telle sorte que la roue 174 soit en appui sur la came 164 lorsque le châssis 108 débute sa course, c'est-à-dire que le châssis 108 est dans une position éloignée du bloc d'appui 148. Ensuite, la came 164 présente une forme en creux vers le bas si bien que le bloc d'entrainement/positionnement entraîné par son poids se déplace verticalement vers le bas. La tourelle 168, qui est en prise avec la bande support sur laquelle sont disposés des composants (non illustrés sur les figures 10 à 13, il est fait référence ici au premier mode de réalisation et aux figures 1, 2 et 5) entraine ladite bande vers le bas jusqu'à ce qu'un composant vienne reposer sur la lame verticale 146.

On retrouve pour ce deuxième mode de réalisation un fonctionnement similaire à celui du premier mode de réalisation. En effet, pour réaliser la séparation d'un composant électronique comportant deux pattes d'une bande support perforée, la bande support est entrainée par un mécanisme d'entrainement de manière à venir placer un composant dans un poste de séparation formé ici par les outils guidés par le bloc guide outil 125 et le bloc d'appui 148. Le dispositif de séparation prévoit le déplacement de la bande support portant les composants électroniques le long d'un parcours prédéterminé délimité par exemple par une ceinture de guidage 192.

Une fois le composant électronique positionné, une lame verticale 146 servant par la suite de butée est introduite sous le composant proprement dit entre ses deux pattes. La lame verticale se trouve alors entre ledit composant et la bande support.

Par action du vérin 200 et/ou du vérin agissant sur le châssis 108, le repère 140 vient pincer avec son bord transversal avant 144 les deux pattes du composant contre le bloc d'appui 148. La contrainte sur les pattes est limitée grâce à la présence du ressort 132. La contrainte est limitée de telle sorte qu'une traction verticale sur la bande support vers le bas puisse entrainer le composant électronique avec la bande support vers le bas. Cette contrainte est exercée par le poids du bloc d'entrainement/positionnement grâce à la coopération de la roue 174 avec la came 164. Cette traction verticale vers le bas amène le composant électronique au contact de la lame verticale 146. Une fois ce contact réalisé, une lame 118, actionnée par le vérin agissant sur le châssis 108, vient couper les pattes du composant (en coopérant avec le bloc d'appui 148).

Le dispositif des figures 10 à 13 permet en outre de réaliser un centrage préalable du composant électronique comme expliqué ci-après.

Il est prévu qu'en début de cycle de coupe, le vérin 198 agisse pour faire avancer vers le bloc d'appui 148 l'outil de recentrage 194. Lors de cette opération, par le doigt de liaison 206, le guide serre flanc 134 est entrainé (avec un retard éventuel compte tenu du jeu au niveau du doigt de liaison 206). Le repère 140 avant son bord transversal avant 144 vient assurer le serrage des pattes contre le bloc d'appui 148.

Pendant ce temps, le châssis 108 avance vers le bloc d'appui 148 en entrainant avec lui le guide lame 116. Cette avancée comprime le ressort 132 et la contrainte correspondante est exercée sur les pattes du composant. Pendant cette phase de contrainte, la roue 174 se déplace sur la came 164 et arrive au niveau de la dépression de celle-ci. La tourelle 168 par l'intermédiaire de ses tiges 176 vient entrainer vers le bas la bande support et le composant vient en appui sur le repère 140, plus précisément sur le bord supérieur de la lame verticale 146. Le positionnement du composant est alors réalisé. Les pattes de celui-ci peuvent être coupées. La lame 118 est montée sur le guide lame 116 de telle sorte que le bord tranchant de la lame 118 n'arrive pas au niveau du bord transversal avant 144 du serre flanc (repère 140) avant que la roue 174 ne se trouve au-dessus de la dépression de la came 164. En continuant la course du châssis 108, la découpe des pattes du composant est réalisée.

Lorsque la découpe est réalisée, le châssis 108 s'éloigne du bloc d'appui 148. Le repère 140 continue à exercer une pression sur les pattes du composant et maintient ainsi ce composant en place. Un dispositif de préhension peut alors venir saisir le composant avant que le recul du châssis ne vienne libérer les pattes du composant.

### Application industrielle

Les dispositifs décrits ci-dessus dans deux formes de réalisation avantageuses permettent chacun de venir séparer des composants radiaux de leur bande support en garantissant toujours une même longueur de pattes après séparation.

En outre, dans la première forme de réalisation illustrée, on remarque que le dispositif peut venir s'adapter à un dispositif d'entrainement de bande support perforée de composants radiaux déjà existant. Dans la deuxième forme de réalisation, un changement de tourelle du dispositif d'entrainement est nécessaire pour s'adapter à un autre type de bande support (perforations réalisées avec un pas différent).

Les dispositifs décrits sont aussi conçus pour s'adapter à la plupart des composants radiaux. En effet, de manière préférée mais optionnelle, la hauteur de coupe est réglable. On remarque que la pièce appelée repère est positionnée de manière à être facilement accessible. Cette pièce est la seule à changer pour s'adapter d'un type de composants à un autre type de composants.

Comme indiqué aussi, ces dispositifs peuvent s'adapter à plusieurs types de bandes supports et à divers positionnements des composants sur une bande support perforée. Ces dispositifs sont ainsi quasi universels.

La présente divulgation ne se limite pas au procédé, à la forme de réalisation d'un dispositif et à ses variantes décrits ci-avant, seulement à titre d'exemple mais elle englobe toutes les variantes que pourra envisager l'homme de l'art dans le cadre des revendications annexées.

## Revendications

1. Procédé de séparation d'un composant (2) électronique radial comportant deux pattes d'une bande support (4) perforée, ledit composant étant fixé sur la bande support (4) perforée par les extrémités libres de ses pattes, **caractérisé en ce qu'**il comporte les étapes suivantes :
- mise en place d'un composant (2) par action sur la bande support perforée dans un poste de séparation, la bande se déplaçant le long d'un parcours prédéterminé,
- introduction d'une butée (46 ; 146) mobile entre les pattes du composant (2), entre le composant (2) électronique et sa bande support (4) perforée,
- pincement des deux pattes du composant (2) avec une contrainte contrôlée,
- positionnement du composant (2) par traction sur la bande support (4) perforée dans une direction opposée au composant (2) électronique de manière à assurer un contact du composant (2) électronique avec la butée (46 ; 146), et
- découpe des deux pattes du composant (2).

2. Dispositif de séparation d'un composant (2) électronique radial comportant deux pattes d'une bande support (4) perforée, ledit composant étant fixé sur la bande support (4) perforée par les extrémités libres de ses pattes, **caractérisé en ce qu'**il comporte :
- des moyens de déplacement d'une bande support (4) perforée le long d'un parcours prédéterminé,
- une butée mobile (46 ; 146) entre une première position en dehors du parcours prédéterminé et une seconde position intersectant le parcours prédéterminé,
- un dispositif de serrage avec un serre flanc (40 ; 140) et une butée fixe (48 ; 148) disposés de part et d'autre du parcours prédéterminé,
- des moyens (76 ; 176) destinés à coopérer avec la bande support (4) perforée pour permettre un positionnement du composant par traction sur la bande support, et
- des moyens de découpe (18) destinés à couper deux pattes de composant électronique.

3. Dispositif de séparation selon la revendication 2, **caractérisé en ce que** les moyens de découpe comportent une lame (18 ; 118) mobile en translation selon une direction dite direction de découpe.

4. Dispositif de séparation selon la revendication 3, **caractérisé en ce que** la butée mobile (46 ; 146) est en saillie par rapport à la lame (18 ; 118) dans le sens de la découpe.

5. Dispositif de séparation selon l'une des revendications 3 ou 4, **caractérisé en ce qu'**il comporte, d'une part, un bâti (24 ; 124, 125) et, d'autre part, un chariot (8 ; 108) mobile en translation par rapport audit bâti selon la direction de découpe.

6. Dispositif de séparation selon la revendication 5, **caractérisé en ce que** le bâti (24 ; 124, 125) porte :
- un premier ensemble avec la lame (18 ; 118), et
- un second ensemble avec la butée mobile (46 ; 146) et le serre flanc (42, 44 ; 142, 144),
**en ce que** le premier ensemble est guidé en translation par rapport au bâti (24 ; 124, 125),
**en ce que** le second ensemble est guidé en translation par rapport au premier ensemble, des moyens élastiques (32; 132) étant prévus entre le premier ensemble et le second ensemble.

7. Dispositif de séparation selon la revendication 6, **caractérisé en ce que** le premier ensemble avec la lame (18) présente en outre un porte lame (16) muni d'un alésage dans lequel coulisse une tête de piston (30) précontrainte élastiquement, la tête de piston (30) étant associée à une tige de piston destinée à pouvoir venir en appui sur le second ensemble.

8. Dispositif de séparation selon l'une des revendications 6 ou 7, **caractérisé en ce qu'**il comporte en outre un outil de centrage (194) disposé au-dessus du second ensemble, une liaison mécanique (206) étant prévue entre, d'une part, la butée mobile (146) et le serre flanc 144) et, d'autre part, l'outil de centrage (194).

9. Dispositif de séparation selon la revendication 8, **caractérisé en ce que** l'outil de centrage (194) est entrainé en translation par un vérin (198) dédié au déplacement de cet outil de centrage (194).

10. Dispositif de séparation selon l'une des revendications 5 à 9, **caractérisé en ce qu'**il comporte en outre au moins une tige (76) orientée sensiblement selon la direction de découpe qui est sensiblement horizontale, et ce que ladite tige (76) est mobile sensiblement selon la direction de découpe et aussi verticalement.

11. Dispositif de séparation selon la revendication 10, **caractérisé en ce que** ladite au moins une tige (76) est montée sur un plateau (66), **en ce que** ledit plateau est monté pivotant par rapport au chariot (8) autour d'un axe sensiblement parallèle et perpendiculaire à la direction de découpe, et **en ce que** le plateau (66) repose sur des moyens de guidage de type came (64) permettant au plateau (66) d'avoir au cours de la course du chariot (8) une portion de déplacement sensiblement parallèle à la direction de découpe puis une autre portion de déplacement avec une composante verticale.

12. Dispositif de séparation selon l'une des revendications 5 à 9, **caractérisé en ce qu'**il comporte en outre une tourelle (168) motorisée comportant des tiges (176) radiales, et **en ce que** ladite tourelle (168) motorisée fait partie d'un bloc mobile verticalement.

13. Dispositif de séparation selon l'une des revendications 5 à 12, **caractérisé en ce que** la direction de découpe est sensiblement horizontale, et **en ce que** le bâti (24 ; 124, 125) est réglable verticalement en hauteur par rapport aux moyens de déplacement de la bande support.

14. Dispositif de séparation selon l'une des revendications 5 à 13, **caractérisé en ce que** le bâti comporte, d'une part, une face horizontale (54) pour recevoir et guider la butée mobile (46 ; 146), le serre flanc (42, 44 ; 142, 144) et les moyens de découpe (18 ; 118) et, d'autre part, une platine (58) portant la butée fixe coopérant avec le serre flanc, une fente permettant le passage d'une bande support de composants électroniques étant prévue entre la face horizontale et la platine.

## Patentansprüche

1. Verfahren zum Trennen eines radialen elektronischen Bauteils (2), das zwei Beine aufweist, von einem perforierten Trägerband (4), wobei das Bauteil durch die freien Enden seiner Beine auf dem perforierten Trägerband (4) befestigt ist, **dadurch gekennzeichnet, dass** es die folgenden Schritte umfasst:
- Bereitstellen eines Bauteils (2) durch Einwirkung auf das perforierte Trägerband in einer Trennstation, wobei sich das Band entlang einer vorbestimmten Bahn bewegt,
- Einführen eines Anschlags (46; 146) zwischen die Beine des Bauteils (2), zwischen das elektronische Bauteil (2) und sein perforiertes Trägerband (4),
- Einklemmen der beiden Beine des Bauteils (2) mit einer kontrollierten Spannung,
- Positionieren des Bauteils (2) durch Zug auf das perforierte Trägerband (4) in einer dem elektronischen Bauteil (2) entgegengesetzten Richtung, um einen Kontakt des elektronischen Bauteils (2) mit dem Anschlag (46; 146) zu gewährleisten, und
- Durchschneiden der beiden Beine des Bauteils (2).

2. Vorrichtung zum Trennen eines radialen elektronischen Bauteils (2), das zwei Beine aufweist, von einem perforierten Trägerband (4), wobei das Bauteil durch die freien Enden seiner Beine auf dem perforierten Trägerband (4) befestigt ist, **dadurch gekennzeichnet, dass** sie umfasst:
- Mittel zum Bewegen eines perforierten Trägerbands (4) entlang einer vorbestimmten Bahn,
- einen Anschlag (46; 146), der zwischen einer ersten Position außerhalb der vorbestimmten Bahn und einer zweiten Position, die die vorbestimmte Bahn schneidet, beweglich ist,
- eine Klemmvorrichtung mit einer Flankenklemme (40; 140) und einem ortsfesten Anschlag (48; 148), die auf beiden Seiten der vorbestimmten Bahn angeordnet sind,
- Mittel (76; 176), die dazu bestimmt sind, mit einem perforierten Trägerband (4) zusammenzuwirken, um eine Positionierung des Bauteils durch Zug auf das Trägerband zu ermöglichen, und
- Schneidmittel (18), die dazu bestimmt sind, zwei Beine eines elektronischen Bauteils zu durchschneiden.

3. Trennvorrichtung nach Anspruch 2, **dadurch gekennzeichnet, dass** die Schneidmittel eine Klinge (18; 118) umfassen, die entlang einer als Schneidrichtung bezeichneten Richtung translatorisch beweglich ist.

4. Trennvorrichtung nach Anspruch 3, **dadurch gekennzeichnet, dass** der bewegliche Anschlag (46; 146) in Schneidrichtung über die Klinge (18; 118) hinausragt.

5. Trennvorrichtung nach einem der Ansprüche 3 oder 4, **dadurch gekennzeichnet, dass** sie einerseits ein Gestell (24; 124, 125) und andererseits einen Schlitten (8; 108) umfasst, der bezüglich des Gestells entlang der Schneidrichtung translatorisch beweglich ist.

6. Trennvorrichtung nach Anspruch 5, **dadurch gekennzeichnet, dass** das Gestell (24; 124, 125) trägt:
- eine erste Baugruppe mit der Klinge (18; 118) und
- eine zweite Baugruppe mit dem beweglichen Anschlag (46; 146) und der Flankenklemme (42, 44; 142, 144),
dass die erste Baugruppe in Bezug auf das Gestell (24; 124, 125) translatorisch geführt wird,
dass die zweite Baugruppe in Bezug auf die erste Baugruppe translatorisch geführt wird, wobei zwischen der ersten Baugruppe und der zweiten Baugruppe elastische Mittel (32; 132) vorgesehen sind.

7. Trennvorrichtung nach Anspruch 6, **dadurch gekennzeichnet, dass** die erste Baugruppe mit der Klinge (18) außerdem einen Klingenhalter (16) aufweist, der mit einer Bohrung versehen ist, in der ein elastisch vorgespannter Kolbenkopf (30) gleitet, wobei der Kolbenkopf (30) mit einer Kolbenstange verbunden ist, die dazu bestimmt ist, an der zweiten Baugruppe zur Anlage kommen zu können.

8. Trennvorrichtung nach einem der Ansprüche 6 oder 7, **dadurch gekennzeichnet, dass** sie außerdem ein Zentrierwerkzeug (194) umfasst, das über der zweiten Baugruppe angeordnet ist, wobei eine mechanische Verbindung (206) zwischen einerseits dem beweglichen Anschlag (146) und der Flankenklemme (144) und andererseits dem Zentrierwerkzeug (194) vorgesehen ist.

9. Trennvorrichtung nach Anspruch 8, **dadurch gekennzeichnet, dass** das Zentrierwerkzeug (194) durch einen Zylinder (198), der für die Bewegung dieses Zentrierwerkzeugs (194) vorgesehen ist, translatorisch angetrieben wird.

10. Trennvorrichtung nach einem der Ansprüche 5 bis 9, **dadurch gekennzeichnet, dass** sie außerdem mindestens einen Stift (76) umfasst, der im Wesentlichen entlang der Schneidrichtung ausgerichtet ist, die im Wesentlichen horizontal ist, und dass der Stift (76) im Wesentlichen entlang der Schneidrichtung und auch vertikal beweglich ist.

11. Trennvorrichtung nach Anspruch 10, **dadurch gekennzeichnet, dass** der mindestens eine Stift (76) auf einer Platte (66) montiert ist, dass die Platte in Bezug auf den Schlitten (8) um eine Achse schwenkbar montiert ist, die im Wesentlichen parallel und senkrecht zur Schneidrichtung ist, und dass die Platte (66) auf Führungsmitteln vom Typ Nocken (64) ruht, die es ermöglichen, dass die Platte (66) während des Laufs des Schlittens (8) einen Bewegungsabschnitt im Wesentlichen parallel zur Schneidrichtung und dann einen anderen Bewegungsabschnitt mit einer vertikalen Komponente aufweist.

12. Trennvorrichtung nach einem der Ansprüche 5 bis 9, **dadurch gekennzeichnet, dass** sie außerdem einen motorisierten Revolverkopf (168) mit radialen Stiften (176) umfasst und dass der motorisierte Revolverkopf (168) Teil eines vertikal beweglichen Blocks ist.

13. Trennvorrichtung nach einem der Ansprüche 5 bis 12 **dadurch gekennzeichnet, dass** die Schneidrichtung im Wesentlichen horizontal ist, und dass das Gestell (24; 124, 125) in Bezug auf die Mittel zum Bewegen des Trägerbandes vertikal in der Höhe verstellbar ist.

14. Trennvorrichtung nach einem der Ansprüche 5 bis 13, **dadurch gekennzeichnet, dass** das Gestell einerseits eine horizontale Fläche (54) zur Aufnahme und Führung des beweglichen Anschlags (46; 146), der Flankenklemme (42, 44; 142, 144) und der Schneidmittel (18; 118) und andererseits eine Platine (58) aufweist, die den ortsfesten Anschlag trägt, der mit der Flankenklemme zusammenwirkt, wobei zwischen der horizontalen Fläche und der Platine ein Schlitz vorgesehen ist, der den Durchlauf eines Trägerbandes für elektronische Bauteile ermöglicht.

## Claims

1. A method for separating a radial electronic component (2) including two leads off a perforated support strip (4), said component being fastened to the perforated support strip (4) by the free ends of its leads, **characterised in that** it includes the following steps:
- setting up a component (2) by action on the perforated support strip in a separation station, the strip moving along a predetermined path,
- inserting a movable stop (46; 146) between the leads of the component (2), between the electronic component (2) and its perforated support strip (4),
- pinching the two leads of the component (2) with a controlled stress,
- positioning the component (2) by pulling on the perforated support strip (4) according to a direction opposite to the electronic component (2) so as to ensure contact of the electronic component (2) with the stop (46; 146), and
- cutting the two leads of the component (2).

2. A device for separating a radial electronic component (2) including two leads off a perforated support strip (4), said component being fastened to the perforated support strip (4) by the free ends of its leads, **characterised in that** it includes:
- means for actuating a support strip (4) perforated along a predetermined path,
- a movable stop (46; 146) between a first position outside the predetermined path and a second position intersecting the predetermined path,
- a clamping device with a blank holder (40; 140) and a fixed stop (48; 148) arranged on either side of the predetermined path,
- means (76; 176) intended to cooperate with the perforated support strip (4) to enable positioning of the component by pulling on the support strip, and
- cutting means (18) intended to cut two leads of an electronic component.

3. The separation device according to claim 2, **characterised in that** the cutting means include a blade (18; 118) movable in translation according to a direction called the cutting direction.

4. The separation device according to claim 3, **characterised in that** the movable stop (46; 146) projects with respect to the blade (18; 118) according to the cutting direction.

5. The separation device according to one of claims 3 or 4, **characterised in that** it includes, on the one hand, a frame (24; 124, 125) and, on the other hand, a carriage (8; 108) movable in translation relative to said frame according to the cutting direction.

6. The separation device according to claim 5, **characterised in that** the frame (24; 124, 125) carries:
- a first assembly with the blade (18; 118), and
- a second assembly with the movable stop (46; 146) and the blank holder (42, 44; 142, 144),
**in that** the first assembly is guided in translation relative to the frame (24; 124, 125), **in that** the second assembly is guided in translation relative to the first assembly, elastic means (32; 132) being provided between the first assembly and the second assembly.

7. The separation device according to claim 6, **characterised in that** the first assembly with the blade (18) further has a blade carrier (16) provided with a bore in which slides an elastically pre-stressed piston head (30), the piston head (30) being associated with a piston rod intended to be able to bear on the second assembly.

8. The separation device according to one of claims 6 or 7, **characterised in that** it further incudes a centring tool (194) arranged above the second assembly, a mechanical connection (206) being provided between, on one hand, the movable stop (146) and the blank holder (144) and, on the other hand, the centring tool (194).

9. The separation device according to claim 8, **characterised in that** the centring tool (194) is driven in translation by a cylinder (198) dedicated to the actuation of this centring tool (194).

10. The separation device according to one of claims 5 to 9, **characterised in that** it further includes at least one rod (76) oriented substantially according to the cutting direction which is substantially horizontal, and **in that** said rod (76) is movable substantially according to the cutting direction and also vertically.

11. The separation device according to claim 10, **characterised in that** said at least one rod (76) is mounted on a tray (66), **in that** said tray is pivotally mounted relative to the carriage (8) about an axis substantially parallel and perpendicular to the cutting direction, and **in that** the tray (66) rests on cam-type guide means (64) enabling the tray (66) to have over the stroke of the carriage (8) a movement portion substantially parallel to the cutting direction then another movement portion with a vertical component.

12. The separation device according to one of claims 5 to 9, **characterised in that** it further includes a motor-driven turret (168) including radial rods (176), and **in that** said motor-driven turret (168) is part of a vertically movable block.

13. The separation device according to one of claims 5 to 12, **characterised in that** the cutting direction is substantially horizontal, and **in that** the frame (24; 124, 125) is vertically adjustable in height with respect to the means for actuating the support strip.

14. The separation device according to one of claims 5 to 13, **characterised in that** the frame includes, on the one hand, a horizontal face (54) for receiving and guiding the movable stop (46; 146), the blank holder (42, 44; 142, 144) and the cutting means (18; 118) and, on the other hand, a plate (58) carrying the fixed stop cooperating with the blank holder, a slot enabling the passage of a support strip of electronic components being provided between the horizontal face and the plate.
